# EUROPEAN PATENT APPLICATION

(11) **EP 4 450 560 A1**
(43) Date of publication of application: **23.10.2024**
(21) Application number: 22907449.7
(22) Date of filing: 13.12.2022
(51) Int. Cl.: C08L 83/07, C08L 83/05, H01L 23/29, H01L 23/31

(54) **UV-CURABLE SILICONE COMPOSITION**

(30) Priority: 17.12.2021 JP 2021205233
(71) Applicant: Momentive Performance Materials Japan LLC, Tokyo 107-6119 (JP)
(72) Inventor: MOCHIZUKI Kikuo, Tokyo 107-6119 (JP)
(74) Representative: Müller-Boré & Partner Patentanwälte PartG mbB
(86) International application number: PCT/JP2022/045907
(87) International publication number: WO 2023/112925

(57) **Abstract**

A UV-curable silicone composition having excellent curability and storage stability is provided. The UV-curable silicone composition includes a polyorganosiloxane (A) containing at least one alkenyl group in the molecule and having an alkenyl group content of 0.3 mmol/g or less on average; a polyorganohydrogensiloxane (B) having at least three silicon-bonded hydrogen atoms in the molecule; and a UV-active platinum catalyst (C).

## Description

### TECHNICAL FIELD

The present invention relates to a UV-curable silicone composition, and more particularly to a UV-curable silicone composition that gives cured products suitably used as sealants, such as electronic component encapsulants, optical component encapsulants, and bonding materials.

### BACKGROUND ART

Silicone compositions have excellent heat resistance and exhibit good adhesion and bonding properties with respect to, for example, semiconductor devices, such as ICs and LSIs; electric and electronic components populated with such semiconductor devices, capacitors, resistors, and the like; and optical components, such as lenses, mirrors, filters, and prisms. In these components, for example, silicone compositions are used as elastic adhesives, sealants, coating materials, and electrically insulating sealing materials. In particular, UV-curable addition reaction-type silicone compositions that utilize hydrosilylation have gained wide use because they can be cured by short time UV irradiation, thereby offering excellent productivity, and can bond members together satisfactorily.

Among such UV-curable silicone compositions, Patent Literature 1 discloses a UV-curable organopolysiloxane gel composition for a damping material for an objective lens driving device that includes specific proportions of (A) an organopolysiloxane having an average of 0.1 or more silicon-bonded alkenyl group in the molecule; (B) an organohydrogenpolysiloxane having two or more silicon-bonded hydrogen atoms in the molecule; and (C) a photoactive platinum complex curing catalyst. The composition is described as both offering a certain advantage in polymer design and having quick UV curability.

Furthermore, Patent Literature 2 discloses a UV-curable liquid silicone composition for an image display device that has a predetermined viscosity and includes specific proportions of (A) an organopolysiloxane having a viscosity at 25°C of 50 to 100,000 mPa·s and containing at least two alkenyl groups in the molecule; (B) an organohydrogenpolysiloxane, for example, a linear organohydrogenpolysiloxane having silicon-bonded hydrogen atoms (Si-H groups) only at both terminals of the molecular chain; and (C) one or more kinds of photoactive hydrosilylation reaction catalysts selected from specific compounds. The composition is described as being able to be cured in several minutes to several tens of minutes under mild temperature conditions of 100°C or below to give a cured product having good mechanical properties and optical properties.

### CITATION LIST

### Patent Literature

Patent Literature 1: JP 2003-213132 A
Patent Literature 2: JP 2019-210351 A

### SUMMARY OF INVENTION

### Technical Problem

The UV-curable silicone compositions disclosed in Patent Literatures 1 and 2 are cured by UV irradiation and come to exhibit predetermined mechanical properties and optical properties. However, the compositions are poor in storage stability and increase their viscosity or alter the curability over time to cause a problem that the quality of cured products is unstable.

In order to solve the storage stability problem, compositions are also prepared as two-component systems. Even in this case, one of the two agents, specifically, the composition containing a photoactive curing catalyst alters its viscosity and curability over time. Thus, there is a demand for two-component UV-curable silicone resin compositions with improved storage stability.

An object of the present invention is to provide a UV-curable silicone composition having excellent curability and storage stability.

### Solution to Problem

In order to solve the problems discussed above, the present inventors carried out extensive studies focusing on alkenyl group-containing polyorganosiloxanes and polyorganohydrogensiloxanes as constituents for UV-curable silicone compositions and have consequently found that the storage stability of a composition can be improved without impairing the curability by using a polyorganosiloxane having a specific content of alkenyl groups, and using a specific polyorganohydrogensiloxane. The present invention has been completed based on the finding.

The present invention pertains to the following [1] to [9].
[1] A UV-curable silicone composition comprising a polyorganosiloxane (A) containing at least one alkenyl group in the molecule and having an alkenyl group content of 0.3 mmol/g or less on average; a polyorganohydrogensiloxane (B) having at least three hydrogen atoms bonded to silicon atoms in the molecule; and a UV-active platinum catalyst (C).
[2] The UV-curable silicone composition according to [1], wherein the alkenyl group in the component (A) is a vinyl group, and the vinyl group content is 0.001 to 0.3 mmol/g on average.
[3] The UV-curable silicone composition according to [1] or [2], wherein the content of the hydrogen atoms bonded to silicon atoms in the component (B) is 5.5 mmol/g or more on average.
[4] The UV-curable silicone composition according to any one of [1] to [3], wherein the component (B) comprises a polyorganohydrogensiloxane (B1) containing an R^{c1}₂HSiO_{1/2} unit (wherein R^{c1} independently at each occurrence is a C₁-C₆ alkyl group or a C₆-C₂₀ aryl group) and a SiO_{4/2} unit.
[5] The UV-curable silicone composition according to [4], wherein the component (B1) is a polyorganohydrogensiloxane having a structure in which 3 to 6 SiO_{4/2} units and 6 to 12 R^{c1}₂HSiO_{1/2} units are bonded to each other.
[6] The UV-curable silicone composition according to any one of [1] to [5], wherein the component (C) is a platinum catalyst having a cyclic diene compound as a ligand.
[7] The UV-curable silicone composition according to any one of [1] to [6], wherein the UV-curable silicone composition comprises a first agent and a second agent, the first agent comprises the component (A) and the component (C) and is free from the component (B), and the second agent comprises the component (B) and is free from the component (C).
[8] A sealant comprising a cured product of the UV-curable silicone composition described in any one of [1] to [7].
[9] The sealant according to [8], which is an electronic component encapsulant, an optical component encapsulant, or a bonding material.

### Advantageous Effects of Invention

According to the present invention, a UV-curable silicone composition having excellent curability and storage stability is provided.

### DESCRIPTION OF EMBODIMENTS

The UV-curable silicone composition comprises a polyorganosiloxane (A) containing at least one alkenyl group in the molecule and having an alkenyl group content of 0.3 mmol/g or less on average; a polyorganohydrogensiloxane (B) having at least three hydrogen atoms bonded to silicon atoms in the molecule; and a UV-active platinum catalyst (C). The UV-curable silicone composition can attain excellent curability and storage stability by virtue of the use of the component (A) having an alkenyl group content of 0.3 mmol/g or less on average and the polyorganohydrogensiloxane (B) having at least three hydrogen atoms bonded to silicon atoms in the molecule.

As used herein, the term "organic group" means a group that contains carbon. The valence of an organic group is described as "n-valent" where n is any of a natural number. Thus, for example, a "monovalent organic group" means a group that contains carbon and can be bonded to the other atom or group with one single bond. The valence bond may be present on an element other than carbon. Even when the valence is not explicitly stated, those skilled in the art can understand the appropriate valence from the context.

As used herein, the term "hydrocarbon group" means a group that contains carbon and hydrogen and results from the detachment of at least one hydrogen atom from the molecule. Examples of such hydrocarbon groups include, but are not particularly limited to, C₁-C₂₀ hydrocarbon groups, such as, for example, aliphatic hydrocarbon groups and aromatic hydrocarbon groups, optionally substituted with one or more substituents. The "aliphatic hydrocarbon groups" may be linear, branched, or cyclic, and may be saturated or unsaturated. The hydrocarbon groups may also contain one or more ring structures. The hydrocarbon groups may have, at a terminal or within the molecular chain, one or more heteroatoms or heteroatom-containing structures, such as nitrogen atoms (N), oxygen atoms (O), sulfur atoms (S), silicon atoms (Si), amide bonds, sulfonyl bonds, siloxane bonds, carbonyl groups, and carbonyloxy groups.

As used herein, the substituents on the "hydrocarbon groups" are not particularly limited and may be selected from, for example, halogen atoms; and C₁-C₆ alkyl groups, C₂-C₆ alkenyl groups, C₂-C₆ alkynyl groups, C₃-C₁₀ cycloalkyl groups, C₃-C₁₀ unsaturated cycloalkyl groups, 5-10 membered heterocyclyl groups, 5-10 membered unsaturated heterocyclyl groups, C₆-C₁₀ aryl groups, and 5-10 membered heteroaryl groups, each optionally substituted by one or more halogen atoms.

In the present specification, alkyl groups and phenyl group may be unsubstituted or substituted unless otherwise specified. Substituents on these groups are not particularly limited and may be, for example, one or more groups selected from halogen atoms, C₁-C₆ alkyl groups, C₂-C₆ alkenyl groups, and C₂-C₆ alkynyl groups.

In the present specification, the structure of a siloxane compound is sometimes described using the abbreviations below to indicate the structural units in the siloxane compound. Hereinafter, these structural units are sometimes written as, for example, "M units", "D units", and the like.
M: (CH₃)₃SiO_{1/2}
M^{H}: H(CH₃)₂SiO_{1/2}
M^{Vi}: CH₂=CH(CH₃)₂SiO_{1/2}
D: (CH₃)₂SiO_{2/2}
D^{H}: H(CH₃)SiO_{2/2}
D^{Vi}: CH₂=CH(CH₃)SiO_{2/2}
T: CH₃SiO_{3/2}
Q: SiO_{4/2} (tetrafunctional)

Siloxane compounds are constructed by a combination of the above structural units. The siloxane compounds may include, at least partially, structural units corresponding to the above structural units except that the methyl groups are replaced with other groups, for example, halogens, such as fluorine, and hydrocarbon groups, such as phenyl groups. It is understood that, for example, the notation D^{H}₂₀D₂₀ does not mean that 20 D^{H} units are continuous and followed by a continuation of 20 D units, and the respective units may be arranged in any manner. The T units or the Q units allow the siloxane compounds to take various three-dimensional structures.

### <Polyorganosiloxanes (A) containing at least one alkenyl group in the molecule and having an alkenyl group content of 0.3 mmol/g or less on average>

The component (A) is a polyorganosiloxane containing at least one alkenyl group in the molecule and having an alkenyl group content of 0.3 mmol/g or less on average. The component (A) serves as a base polymer in the UV-curable silicone composition. The alkenyl group may be bonded to a molecular terminal of the molecular main chain, to a side chain in the middle of the molecular chain, or to both. As used herein, the molecular main chain indicates the longest chain relative to other chains in the molecule. The molecular structure of the component (A) is not particularly limited as long as the main backbone is composed of siloxane bonds, and may be linear, branched, cyclic, or three-dimensional network. The siloxane skeleton may be interrupted by a divalent organic group. The components (A) may be used singly, or two or more may be used in combination.

The component (A) contains at least one alkenyl group in the molecule. The component (A) may be a mixture of polyorganosiloxanes containing at least one alkenyl group in the molecule. For example, the component (A) may be a mixture of a polyorganosiloxane containing one alkenyl group in the molecule and a polyorganosiloxane containing two or more alkenyl groups in the molecule. In order to enhance the curability and to impart appropriate hardness to cured products, the component (A) preferably includes 30 mass% or more, more preferably 50 mass% or more, and still more preferably 80 mass% or more of a polyorganosiloxane containing two or more alkenyl groups in the molecule, with respect to 100 mass% of the component (A). The upper limit of the content of a polyorganosiloxane containing two or more alkenyl groups in the molecule is 100 mass% of the component (A) taken as 100 mass%.

In order to strike a balance between curability and storage stability and to impart appropriate hardness to cured products, the component (A) preferably comprises a polyorganosiloxane containing two alkenyl groups in the molecule, and more preferably comprises a linear polyorganosiloxane having one alkenyl group at each terminal of the molecular main chain. In this case, the polyorganosiloxane containing two alkenyl groups in the molecule preferably represents 30 mass% or more, more preferably 50 mass% or more, and still more preferably 80 mass% or more of the component (A) taken as 100 mass%. The upper limit of the content of the polyorganosiloxane containing two alkenyl groups in the molecule is 100 mass% of the component (A) taken as 100 mass%.

The alkenyl group content in the component (A) is 0.3 mmol/g or less on average. By virtue of the alkenyl group content being controlled to the above range, the UV-curable silicone composition can be excellent in both curability and storage stability. When the component (A) is a mixture of polyorganosiloxanes containing at least one alkenyl group in the molecule, the alkenyl group content in the component (A) is the average of the mixture.

From the peak areas of CH₂=CH- groups and CH₃- groups measured by ¹H-NMR, the molar ratios of CH₂=CH- groups and CH₃- groups are determined. The alkenyl group content in the component (A) is calculated from the molecular weight of the component (A) and the number of moles of CH₂=CH- groups determined from the molar ratios. In addition to the results of ¹H-NMR measurement, the calculation may involve the ratios of the units (such as M^{Vi} units and D units) measured by ²⁹Si-NMR.

When the component (A) is a mixture of polyorganosiloxanes, the alkenyl group content in the component (A) is preferably measured as described above. When, however, the alkenyl group contents in the polyorganosiloxanes and the mixing ratio of the polyorganosiloxanes are known, the alkenyl group content in the component (A) may be the average value determined by multiplying the respective alkenyl group contents by the mixing ratio and combining the products.

From the point of view of the balance between curability and storage stability, the alkenyl group content in the component (A) on average is preferably 0.001 to 0.3 mmol/g, more preferably 0.003 to 0.24 mmol/g, still more preferably 0.010 to 0.20 mmol/g, and further more preferably 0.025 to 0.10 mmol/g.

The alkenyl group is not particularly limited as long as the group has a carbon-carbon double bond and can undergo addition reaction. The number of carbon atoms in the alkenyl group is preferably 2 to 20, more preferably 2 to 8, and still more preferably 2 to 6. The alkenyl group may have a branched structure or a ring structure. The carbon-carbon double bond may be located at any position in the hydrocarbon constituting the alkenyl group. From the point of view of reactivity, the carbon-carbon double bond is preferably present at a terminal of the group. For easy synthesis of the polyorganosiloxane, for example, the alkenyl group is preferably a vinyl group. That is, it is preferable that the alkenyl group in the component (A) be a vinyl group and the vinyl group content be 0.001 to 0.3 mmol/g on average.

In an embodiment of the present invention, the component (A) has at least one alkenyl group bonded to a silicon atom in the molecule. The component (A) forms a network structure through addition reaction with hydrosilyl groups (Si-H groups) in the component (B) described later. The molecule of the component (A) typically has at least one alkenyl group-containing siloxane unit represented by general formula (1):

R¹ₘR:²ₙSiO_{(4-m-n)/2} (1)

(wherein
R¹ is an unsubstituted or substituted, monovalent hydrocarbon group having no aliphatic unsaturated bonds;
R² is an alkenyl group;
m is an integer of 0 to 2; and
n is an integer of 1 to 3, with the proviso that m + n is 1 to 3).

R¹ is an unsubstituted or substituted, monovalent hydrocarbon group having no aliphatic unsaturated bonds. Specific examples of R¹ include alkyl groups, for example, C₁-C₆ alkyl groups (such as, for example, methyl, ethyl, and propyl); cycloalkyl groups, for example, C₃-C₁₀ cycloalkyl groups (such as, for example, cyclohexyl); aryl groups, for example, C₆-C₂₀ aryl groups (such as, for example, phenyl, tolyl, xylyl, naphthyl, and anthracenyl); aralkyl groups, for example, C₇-C₁₃ aralkyl groups (such as, for example, 2-phenylethyl and 2-phenylpropyl); and substituted hydrocarbon groups, for example, halogenated hydrocarbon groups (such as, for example, chloromethyl, chlorophenyl, and 3,3,3-trifluoropropyl). For such reasons as easy synthesis, alkyl groups are preferable. In particular, methyl, ethyl, and propyl are preferable, and methyl is more preferable. In order to control the refractive index, an aryl group may be used in combination. In particular, phenyl is preferable for such reasons as easy synthesis.

In order to ensure that the resultant UV-curable silicone composition is excellent in curability and storage stability, the component (A) preferably comprises a linear polyorganosiloxane having one alkenyl group at each terminal of the molecular main chain. In an embodiment of the present invention, for example, the linear polyorganosiloxane may be represented by formula (I): 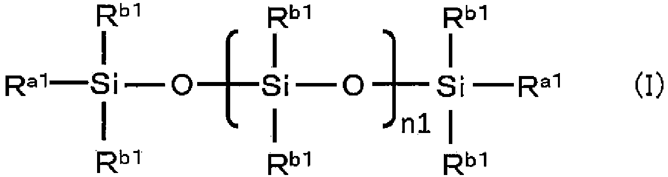 (wherein
R^{a1} independently at each occurrence is a C₂-C₆ alkenyl group,
R^{b1} independently at each occurrence is a C₁-C₆ alkyl group or a C₆-C₂₀ aryl group, and
n1 is such a number that the alkenyl group content in the linear polyorganosiloxane is 0.3 mmol/g or less on average).

Examples of the C₂-C₆ alkenyl groups include vinyl group, allyl group, 3-butenyl group, and 5-hexenyl group. Examples of the C₁-C₆ alkyl groups include methyl group, ethyl group, propyl group, butyl group, pentyl group, and hexyl group. Examples of the C₆-C₂₀ aryl groups include phenyl group, naphthyl group, and anthracenyl group.

R^{a1} is preferably a vinyl group because the synthesis is easy and because the fluidity of the composition before curing and the heat resistance of cured products are not impaired. R^{b1} is preferably a C₁-C₆ alkyl group, particularly preferably a methyl group, because the synthesis is easy and because an excellent balance is obtained in properties, such as the fluidity of the composition and the mechanical strength of cured products. That is, the component (A) is preferably a polymethylvinylsiloxane that has a dimethylvinylsiloxane unit at each terminal and has dimethylsiloxane units as intermediate units.

The content of the polymethylvinylsiloxane that has a dimethylvinylsiloxane unit at each terminal and has dimethylsiloxane units as intermediate units is preferably 30 mass% or more, more preferably 50 mass% or more, and still more preferably 80 mass% or more of the component (A) taken as 100 mass%. The upper limit of the content is 100 mass%.

The component (A) may be a mixture of a polymethylvinylsiloxane that has a dimethylvinylsiloxane unit at each terminal and has dimethylsiloxane units as intermediate units, and the other linear, branched, or cyclic alkenyl group-containing polyorganosiloxane.

In a preferred embodiment of the present invention, the component (A) is such that the alkenyl group is a vinyl group and the vinyl group content is 0.001 to 0.3 mmol/g. From the point of view of the balance between curability and storage stability, the vinyl group content in the component (A) on average is preferably 0.001 to 0.3 mmol/g, more preferably 0.003 to 0.24 mmol/g, still more preferably 0.010 to 0.20 mmol/g, and further more preferably 0.025 to 0.10 mmol/g.

The component (A) may be purchased from the market. Alternatively, an alkenyl group may be introduced into a polyorganosiloxane by a known reaction. The component (A) may be a single kind of compound or may be a mixture of two or more kinds of compounds different from one another in, for example, the positions or the types of substituents, or the degree of polymerization. The component (A), which is a polyorganosiloxane, may be a mixture of polyorganosiloxanes having various degrees of polymerization.

From the point of view of the balance among handleability, curability, and storage stability, the amount of the component (A) is preferably 70.0 to 99.8 mass%, more preferably 80.0 to 99.7 mass%, and still more preferably 90.0 to 99.7 mass% of the UV-curable silicone composition taken as 100 mass%.

### <Polyorganohydrogensiloxanes (B) having at least three hydrogen atoms bonded to silicon atoms in the molecule>

The component (B) is a polyorganohydrogensiloxane having at least three hydrogen atoms bonded to silicon atoms in the molecule. The component (B) serves as a crosslinking agent and undergoes an addition reaction with the alkenyl groups in the component (A) to form a network structure. Compared to a polyorganohydrogensiloxane having two hydrogen atoms bonded to silicon atoms in the molecule, the component (B) offers excellent curability of the composition. Because the component (B) is capable of forming a network structure with the component (A), the composition can attain excellent curability while maintaining storage stability and can give cured products excellent in mechanical properties, even when using a polyorganosiloxane having a low alkenyl group content like the component (A).

The hydrogen atoms in the component (B) may be bonded to a silicon atom at a molecular chain terminal, to a silicon atom in the middle of the molecular chain, or to both. The molecular structure of the component (B) is not particularly limited as long as the main backbone is composed of siloxane bonds, and may be linear, branched, cyclic, or three-dimensional network. The siloxane skeleton may be interrupted by a divalent organic group. The component (B) may have a silicon-bonded hydroxyl group or a silicon-bonded alkoxy group, such as a methoxy group or an ethoxy group. The components (B) may be used singly, or two or more may be used in combination.

The molecule of the component (B) typically has at least three siloxane units containing a hydrogen atom bonded to a silicon atom, that are represented by general formula (2):

R³ₚH_{q}SiO_{(4-p-q)/2} (2)

(wherein
R³ is an unsubstituted or substituted, monovalent hydrocarbon group having no aliphatic unsaturated bonds;
p is an integer of 0 to 2; and
q is an integer of 1 to 3, with the proviso that p + q is 1 to 3). Examples and preferred embodiments of R³ are similar to those of R¹ in general formula (1). In the component (B), the number of hydrogen atoms bonded to silicon atoms is preferably 3 to 100, and more preferably 5 to 50 in the molecule.

From the points of view of the curability of the composition and mechanical properties of cured products, the content of hydrogen atoms bonded to silicon atoms in the component (B) on average is preferably 5.5 mmol/g or more, more preferably 6.0 to 12.0 mmol/g, still more preferably 7.0 to 11.0 mmol/g, and particularly preferably 8.0 to 11.0 mmol/g.

In order to ensure curability and mechanical properties Of cured products, the component (B) preferably comprises a polyorganohydrogensiloxane (B1) containing an R^{c1}₂HSiO_{1/2} unit (wherein R^{c1} independently at each occurrence is a C₁-C₆ alkyl group or a C₆-C₂₀ aryl group) and a SiO_{4/2} unit. When the component (B) comprises the component (B1), the component (B) can contribute to hardness control by making a cured product a network. The component (B1) may be branched, cyclic, or three-dimensional network structure (in which SiO_{4/2} units are densely arranged). For such reasons as easy synthesis, R^{c1} is preferably a C₁-C₆ alkyl group, and particularly preferably methyl.

In particular, the component (B1) is preferably a polyorganohydrogensiloxane having a structure in which 3 to 6 SiO_{4/2} units and 6 to 12 R^{c1}₂HSiO_{1/2} units are bonded to each other; and is particularly preferably a cyclic polyorganohydrogensiloxane in which 3 to 6 SiO_{4/2} units form a cyclic siloxane skeleton and 2 R^{c1}₂HSiO_{1/2} units are bonded to each SiO_{4/2} unit, such as [R^{c1}₂HSiO_{1/2}]₆[SiO_{4/2}]₃, [R^{c1}₂HSiO_{1/2}]₈[SiO_{4/2}]₄, [R^{c1}₂HSiO_{1/2}]₁₀[SiO_{4/2}]₅, or [R^{c1}₂HSiO_{1/2}]₁₂[SiO_{4/2}]₆.

In order to ensure curability and mechanical properties of cured products, the content of the component (B1) in 100 mass% of the component (B) is preferably 50 mass% or more, more preferably 70 mass% or more, and still more preferably 90 mass% or more. The upper limit of the content of the component (B1) in 100 mass% of the component (B) is 100 mass%.

The viscosity of the component (B) at 23°C is preferably 1 to 100 mPa-s, and more preferably 1 to 50 mPa·s. The viscosity is a value measured using a rotational viscometer with No. 1 or No. 2 rotor under conditions of 60 rps and 23°C in accordance with JIS K 6249.

The component (B) may be purchased from the market. Alternatively, the component (B) may be synthesized by a known reaction. The component (B) may be a single kind of compound or may be a mixture of two or more kinds of compounds different from one another in, for example, the positions or the types of substituents, or the degree of polymerization. The component (B), which is a polyorganohydrogensiloxane, may be a mixture of polyorganohydrogensiloxanes having various degrees of polymerization.

From the point of view of the balance among handleability, curability, and storage stability, the component (B) is preferably added so that the number of hydrogen atoms bonded to silicon atoms will be in the range of 0.6 to 2.2 mol per mol of the alkenyl groups in the component (A). The ratio is more preferably in the range of 0.8 to 1.8 mol, still more preferably in the range of 1.0 to 1.6 mol, and particularly preferably in the range of 1.2 to 1.4 mol.

### <UV-active platinum catalysts (C)>

The component (C) is a catalyst that is activated by UV rays and promotes the addition reaction between the alkenyl groups in the component (A) and the hydrosilyl groups (Si-H groups) in the component (B). In order to ensure good catalytic activity, the component (C) is preferably a platinum catalyst having a cyclic diene compound as a ligand. The components (C) may be used singly, or two or more may be used in combination.

Examples of the platinum catalysts having a cyclic diene compound as a ligand include (1,5-cyclooctadienyl) diphenyl platinum complex, (1,5-cyclooctadienyl) dipropyl platinum complex, (2,5-norboradiene) dimethyl platinum complex, (2,5-norboradiene) diphenyl platinum complex, (cyclopentadienyl) dimethyl platinum complex, (methylcyclopentadienyl) diethyl platinum complex, (trimethylsilylcyclopentadienyl) diphenyl platinum complex, (methylcycloocta-1,5-dienyl) diethyl platinum complex, (cyclopentadienyl) trimethyl platinum complex, (cyclopentadienyl) ethyldimethyl platinum complex, (cyclopentadienyl) acetyldimethyl platinum complex, (methylcyclopentadienyl) trimethyl platinum complex, (methylcyclopentadienyl) trihexyl platinum complex, (trimethylsilylcyclopentadienyl) trimethyl platinum complex, (dimethylphenylsilylcyclopentadienyl) triphenyl platinum complex, and (cyclopentadienyl) dimethyltrimethylsilylmethyl platinum complex.

The component (C) is preferably added in such an amount that the mass of platinum metal relative to the total mass of the components (A) and (B) will be 0.1 to 500 ppm, more preferably 1 to 100 ppm, still more preferably 3 to 70 ppm, and particularly preferably 5 to 20 ppm. If the amount of the component (C) is less than 0.1 ppm, the addition reaction induced by UV irradiation may be slow or may not accomplish curing. If the amount is more than 500 ppm, the UV-curable silicone composition tends to be deteriorated in storage stability and yellowing occurs easily in cured products, leading to high costs.

### <Additional components>

The UV-curable silicone composition may contain additional components as long as the purpose and the effects of the composition are not impaired. Exemplary additional components that may be appropriately added include flame retardants, adhesion-imparting agents, heat resistance-imparting agents, diluents, thixotropic agents, such as fumed silica, inorganic or organic pigments, addition reaction curing catalyst inhibitors, and resins other than polyorganosiloxanes. For example, the UV-curable silicone composition may contain polyorganosiloxanes other than the component (A), for example, an alkenyl group-free polyorganosiloxane; polyorganohydrogensiloxanes other than the component (B), for example, a polyorganohydrogensiloxane having two or less hydrogen atoms bonded to silicon atoms in the molecule; and addition reaction curing catalysts other than the component (C), for example, a thermally active addition reaction curing catalyst. The additional components of each category may be used singly, or two or more may be used in combination.

### <Preferred embodiments of the composition>

The UV-curable silicone composition may be a one-component composition comprising all the components (A) to (C), or may be a two-component composition comprising the component (B) and the component (C) in separate containers to further improve the storage stability of the composition.

When the composition is a two-component system, it is preferable that the first agent comprise the component (A) and the component (C) and be free from the component (B), and the second agent comprise the component (B) and be free from the component (C). In this case, the second agent may comprise the component (A). At the time of use of the two-component composition, the first agent and the second agent are mixed together to give the UV-curable silicone composition.

In Examples, compositions are prepared as two-component systems that comprise a first agent consisting solely of the components (A) and (C), and a second agent consisting solely of the component (B), and aging treatment is performed only on the first agent. This is because the evaluation focuses exclusively on the influence of the interaction between the alkenyl groups in the component (A) and the component (C) on storage stability. The use of the component (A) similarly improves the storage stability of the one-component composition that comprises the components (A) and (C) and further comprises the component (B).

### <Methods for producing the UV-curable silicone compositions>

The one-component UV-curable silicone composition may be obtained by mixing the components (A) to (C) and, if necessary, additional components in a mixer, such as a planetary mixer. At the time of mixing, where needed, the components may be mixed while being heated in the range of 50 to 150°C. When the UV-curable silicone composition contains a powder, a kneading operation is preferably performed under high shear force for uniform finish. For example, the kneading device may be a three-roll mill, a colloid mill, or a sand grinder, with a three-roll mill being preferable.

In the case of the two-component UV-curable silicone composition, the first agent and the second agent are prepared separately. The first agent may be obtained by mixing the components (A) and (C), and, if necessary, additional components in a mixer, such as a planetary mixer. The second agent may be obtained by mixing the component (B) and, if necessary, the component (A) and additional components in a mixer, such as a planetary mixer. At the time of mixing, where needed, the components may be mixed while being heated in the range of 50 to 150°C. When the first agent and/or the second agent contains a powder, a kneading operation is preferably performed in the same manner as for the one-component UV-curable silicone composition.

From the point of view of spreadability at the time of application, the viscosity of the UV-curable silicone composition at 23°C is preferably 100,000 mPa·s or less, and more preferably 50 to 50,000 mPa·s. When the UV-curable silicone composition is a two-component composition consisting of a first agent and a second agent, the viscosities of the first agent and the second agent are preferably 10 to 100,000 mPa·s, more preferably 50 to 50,000 mPa·s, and particularly preferably 100 to 20,000 mPa·s. The UV-curable silicone composition is preferably stored at or below room temperature and under light shielding. The viscosities of the UV-curable silicone composition, the first agent, and the second agent are values measured using a viscoelastometer with a 25 mm cone plate at a shear rate of 10/s and 23°C.

### <Methods for curing the UV-curable silicone compositions>

The UV-curable silicone composition may be cured by UV irradiation. The irradiation dose is preferably 100 to 10,000 mJ/cm², more preferably 300 to 6,000 mJ/cm², and still more preferably 500 to 5,000 mJ/cm². Incidentally, the irradiation dose is a value measured with respect to UVA. Here, UVA refers to ultraviolet rays in the range of 315 to 400 nm. The composition exhibits good curability when irradiated with ultraviolet rays having an ultraviolet wavelength, for example, a wavelength in the range of 250 to 450 nm. Examples of the light sources that emit ultraviolet rays having such wavelengths include high-pressure mercury lamp (UV-7000) and metal halide lamp (UVL-4001M3-N1) manufactured by Ushio Inc., metal halide lamp (JM-MTL 2KW) manufactured by JM tech, Korea, UV irradiation lamp (OSBL360) manufactured by Mitsubishi Electric Corporation, UV irradiation machine (UD-20-2) manufactured by GS Yuasa Corporation, fluorescent lamp (FL-20BLB) manufactured by TOSHIBA CORPORATION, H Bulb, H plus Bulb, V Bulb, D Bulb, Q Bulb, and M Bulb manufactured by Heraeus, and LED lamp (HLDL-155UV) manufactured by CCS Inc.

The curing time of the composition depends on the UV irradiation dose, but is generally 30 minutes or less, and preferably 10 minutes or less. The progress of the curing of the composition may be judged visually or may be quantitatively estimated by, for example, measuring the time for the storage elastic modulus G' and the loss elastic modulus G" to become equal or the time for the storage elastic modulus G' to reach a predetermined value. Short curing time and excellent handleability can be advantageously obtained when, for example, the storage elastic modulus G' reaches 100 Pa in 30 minutes or less, preferably 10 minutes or less, at 23°C after UV irradiation.

Cured products of the UV-curable silicone compositions may be suitably used as sealants. An article that uses a cured product of the UV-curable silicone composition as a sealant is excellent in water resistance and durability at the adhesive face and the sealing area. Thus, the cured product may be suitably used as an electronic component encapsulant, an optical component encapsulant, or a bonding material. Furthermore, the UV-curable silicone composition is also excellent in pot life and storage stability. Thus, for example, the composition may be used as an adhesive for bonding in image display devices, such as liquid crystal, plasma, and organic EL image display devices, or as a sealant for sealing LED devices or OLED devices.

### Examples

Hereinbelow, the present invention will be described in greater detail by presenting Examples and Comparative Examples. However, the present invention is not limited by these Examples. References to amounts indicate parts by mass or mass% unless otherwise specified.

### <Components used>

The components used are described below. Here, the symbols mean:
M: (CH₃)₃SiO_{1/2}
M^{H}: H(CH₃)₂SiO_{1/2}
M^{Vi}: CH₂-CH(CH₃)₂SiO_{1/2}
D: (CH₃)₂SiO_{2/2}
D^{H}: H(CH₃)SiO_{2/2}
D^{Vi}: CH₂=CH(CH₃)SiO_{2/2}
Q: SiO_{4/2} (tetrafunctional)

### Components (A): Polyorganosiloxanes containing at least one alkenyl group in the molecule and having an alkenyl group content of 0.3 mmol/g or less on average

The following polymethyl vinyl siloxanes diterminated with M^{Vi} unit and having D units as intermediate units were used.
M^{Vi}Dₘ₁M^{Vi} (1): vinyl group content of 0.030 mmol/g on average
M^{Vi}Dm₂M^{Vi} (2): vinyl group content of 0.049 mmol/g on average
M^{Vi}DₘM^{Vi} (3): vinyl group content of 0.075 mmol/g on average
M^{Vi}Dₘ₄M^{Vi} (4): vinyl group content of 0.178 mmol/g on average
M^{Vi}Dₘ₅M^{Vi} (5): vinyl group content of 0.227 mmol/g on average

### Components (A'): Polyorganosiloxanes other than the components (A)

M^{Vi}Dₘ₆M^{Vi} (6): vinyl group content of 0.341 mmol/g on average
M^{Vi}Dₘ₇M^{Vi} (7): vinyl group content of 0.887 mmol/g on average
M^{Vi}Dₘ₃M^{Vi} (3)/MD^{Vi}Q resin = 60/40: vinyl group content of 0.475 mmol/g on average (MD^{Vi}Q resin has five vinyl groups in the molecule, and the vinyl group content is 1.075 mmol/g.)

The alkenyl group contents in the components (A) and (A') were calculated as follows. From the peak areas of CH₂=CH- groups and CH₃- groups measured by ¹H-NMR, the molar ratios of CH₂=CH- groups and CH₃- groups were determined. The alkenyl group content was calculated from the molecular weight of the component (A) or (A') and the number of moles of CH₂=CH- groups determined from the molar ratios. Specifically, a 5 mass% deuterated chloroform solution of the component (A) or (A') was prepared and was subjected to ¹H-NMR measurement. From the peak area of SiCH=CH₂ groups appearing around 6 ppm and the peak area of SiCH₃ groups appearing around 0 ppm, the molar ratios of CH₂=CH- groups and CH₃- groups were determined. The molecular weight of the component (A) or (A') and the number of moles of CH₂=CH- groups were calculated from the molar ratios. The alkenyl group content in the component (A) or (A') was calculated from the molecular weight of the component (A) or (A') and the number of moles of CH₂=CH- groups thus obtained.

### Component (B): Polyorganohydrogensiloxane having at least three hydrogen atoms bonded to silicon atoms in the molecule

Crosslinkable polymethylhydrogensiloxane having an average unit formula represented by M^{H}₈Q₄ (SiH content: 10.78 mmol/g)

### Component (C): UV-active platinum catalyst

(Methylcyclopentadienyl) trimethyl platinum complex (manufactured by Strem Chemicals, Inc. (Germany), amount of platinum: 61.1 mass%)

### Example 1

The component (C) was handled in a yellow room to prevent catalyst activation by UV rays. The component (C) was diluted to 0.05 mass% with M^{Vi}Dₘ₂M^{Vi} (2). 3.4 parts by mass of the diluted liquid of the component (C) (component (C): 0.00170 parts by mass, M^{Vi}Dₘ₂M^{Vi} (2): 3.39830 parts by mass) and 0.36 parts by mass of the component (B) were added to 100 parts by mass of M^{Vi}Dₘ₁M^{Vi} (1). The mixture was mixed to give a one-component UV-curable silicone composition of Example 1.

### Examples 2 to 6 and Comparative Examples 1 to 3

One-component UV-curable silicone compositions of Examples 2 to 6 and Comparative Examples 1 to 3 were obtained in the same manner as in Example 1, except that the components (A) to (C) in Example 1 and the amounts thereof were changed as described in Table 1.

### [Table 1]

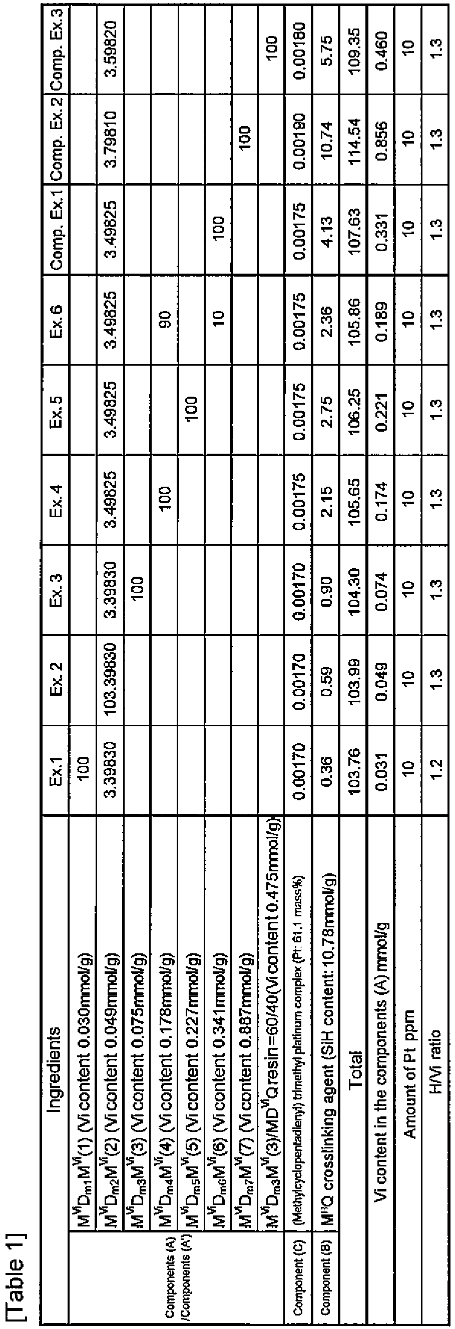

### <Measurement methods>

The viscosity and the gelation time were measured under light shielding conditions.

### [Viscosity]

The viscosity (Pa s) of the UV-curable silicone composition at 23°C was measured using viscoelastometer MCR301 (manufactured by Anton Paar) with a 25 mm cone plate at a shear rate of 10/s for 90 seconds. The results are described in Table 2.

### [Gelation time]

The UV-curable silicone composition was analyzed with viscoelastometer MCR301 (manufactured by Anton Paar) to measure the storage elastic modulus G' over time before and after UV irradiation. An 8 mm parallel plate was set in the viscoelastometer and the measurement was started of the storage elastic modulus G' of the UV-curable silicone composition at 23°C and a frequency of 1 Hz. The UV-curable silicone composition was irradiated with UV rays at an intensity of 100 mW/cm² for 10 seconds (irradiation dose: 1,000 mJ/cm²), and the time from the start of irradiation until the storage elastic modulus G' reached 100 Pa was measured as the gelation time. It was judged that the shorter the gelation time, the faster the curing and the higher the curability. The gelation time was measured until 60 minutes after the start of UV irradiation. When the storage elastic modulus G' had not reached 100 Pa in that time, the gelation time was determined to be > 60 minutes. The results are described in Table 2.

### [Storage stability]

The influence of aging treatment on the viscosity and the gelation time of the UV-curable silicone compositions of Examples 1 to 6 and Comparative Examples 1 to 3 was studied.

### Example 1-1

The component (C) was handled in a yellow room to prevent catalyst activation by UV rays. The component (C) was diluted to 0.05 mass% with M^{Vi}Dₘ₂M^{Vi} (2). 3.4 parts by mass of the diluted liquid of the component (C) (component (C): 0.00170 parts by mass, M^{Vi}Dₘ₂M^{Vi} (2): 3.39830 parts by mass) was added to 100 parts by mass of M^{Vi}Dₘ₁M^{Vi} (1). The mixture was mixed to give a first agent. The first agent was transferred to a light-shielding black resin container, which was then tightly closed. The component (B) was used alone as a second agent. A two-component UV-curable silicone composition of Example 1-1 having the same formulation as in Example 1 was thus obtained.

### Examples 2-1 to 6-1 and Comparative Examples 1-1 to 3-1

Two-component UV-curable silicone compositions of Examples 2-1 to 6-1 and Comparative Examples 1-1 to 3-1 were obtained in the same manner as in Example 1-1, except that the components (A) to (C) in Example 1-1 and the amounts thereof were changed as described in Table 1.

The light-shielding containers containing the first agents of the two-component UV-curable silicone compositions of Examples 1-1 to 6-1 and Comparative Examples 1-1 to 3-1 were stored in a dryer set at 60°C for 2 weeks to perform aging treatment. After the aging treatment, the second agents were admixed with the respective first agents in accordance with the formulations described in Table 1 to give UV-curable silicone compositions. The compositions thus obtained were analyzed to measure the viscosity and the gelation time. The results are described in Table 2.

Furthermore, the rate of change in the viscosity of the composition prepared from the aged first agent was calculated relative to the viscosity of the one-component composition, and the amount of change in the gelation time of the composition prepared from the aged first agent was calculated relative to the gelation time of the one-component composition. The results are described in Table 2. In the table, n.d. indicates that the measurement was impossible.

### [Table 2]

**[Table 2]**

| | Unit | Ex. 1 | Ex.2 | Ex.3 | Ex.4 | Ex.5 | Ex. 6 | Comp. | Ex.1 Comp. | Ex.2 Comp. Ex.3 |
|---|---|---|---|---|---|---|---|---|---|---|
| One-pack system | | | | | | | | | | |
| Viscosity (measured at 23°C and 10/s for 90 s using 25 mm cone plate) | Pa.s | 72.500 | 13.650 | 3.360 | 0.506 | 0.277 | 0.453 | 0.137 | 0.037 | 5.433 |
| Gelation time (UV irradiation (1,000mJ/cm²), 23°C, a mm parallel plate) | min | 0.38 | 0.82 | 1.51 | 2.05 | 3.80 | 3.15 | 15.18 | 31.79 | >60 |

| Two-pack system (prepared after 2 weeks of aging (60°C) of the first agent) | | | | | | | | | | |
|---|---|---|---|---|---|---|---|---|---|---|
| Viscosity (measured at 23°C and 10/s for 90 s using 25 mm cone plate) | Pa.s | 73.350 | 13.600 | 3.430 0.508 | | 0.295 | 0.452 | 0.168 | 0.075 | 8.600 |
| Rate of change | % | 1.2 | -0.4 | 2.1 | 0.4 | 6.5 | -0.2 | 22.6 | 102.7 | 56.3 |
| Gelation time (UV irradiation (1,00mJ/cm²), 23°C. 8 mm parallel plate) | min | 0.58 | 1.18 | 2.06 | 3.27 | 4.32 | 4.18 | 12.66 | 27.75 | >60 |
| Amount of change | min | 0.20 | 0.36 | 0.55 | 1.22 | 0.52 | 1.03 | -2.52 | -4.04 | n.d. |

The UV-curable silicone compositions of Examples included a polyorganosiloxane (A) containing at least one alkenyl group in the molecule and having an alkenyl group content of 0.3 mmol/g or less on average; a polyorganohydrogensiloxane (B) having at least three hydrogen atoms bonded to silicon atoms in the molecule; and a UV-active platinum catalyst (C). As described in Table 2, these compositions had a short gelation time and were excellent in curability. Furthermore, the compositions prepared from the aged first agent had small changes in viscosity and gelation time and were excellent in storage stability. In particular, Examples 1 to 3 and Examples 1-1 to 3-1, in which the alkenyl group content in the component (A) was 0.025 to 0.10 mmol/g on average, resulted in a markedly small change in the gelation time of the composition prepared from the aged first agent, and advantageously also attained excellent curability with a short gelation time regardless of the presence or absence of the aging treatment.

In the UV-curable silicone compositions of Comparative Examples 1 to 3 and Comparative Examples 1-1 to 3-1, the component (A) was replaced with a polyorganosiloxane containing at least one alkenyl group in the molecule and having an alkenyl group content of more than 0.3 mmol/g on average. These compositions had large changes in viscosity and gelation time when prepared after the aging treatment of the first agent, and were shown to be inferior in storage stability. Furthermore, the gelation time was long and the curability was poor regardless of the presence or absence of the aging treatment.

### Industrial Applicability

Cured products of the UV-curable silicone compositions are useful as an electronic component encapsulant, an optical component encapsulant, or a bonding material.

## Claims

1. A UV-curable silicone composition comprising:
a polyorganosiloxane (A) containing at least one alkenyl group in the molecule and having an alkenyl group content of 0.3 mmol/g or less on average;
a polyorganohydrogensiloxane (B) having at least three hydrogen atoms bonded to silicon atoms in the molecule; and
a UV-active platinum catalyst (C).

2. The UV-curable silicone composition according to claim 1, wherein the alkenyl group in the component (A) is a vinyl group, and the vinyl group content is 0.001 to 0.3 mmol/g on average.

3. The UV-curable silicone composition according to claim 1 or 2, wherein the content of the hydrogen atoms bonded to silicon atoms in the component (B) is 5.5 mmol/g or more on average.

4. The UV-curable silicone composition according to claim 1 or 2, wherein the component (B) comprises a polyorganohydrogensiloxane (B1) containing an R^{c1}₂HSiO_{1/2} unit (wherein R^{c1} independently at each occurrence is a C₁-C₆ alkyl group or a C₆-C₂₀ aryl group) and a SiO_{4/2} unit.

5. The UV-curable silicone composition according to claim 4, wherein the component (B1) is a polyorganohydrogensiloxane having a structure in which 3 to 6 SiO_{4/2} units and 6 to 12 R^{c1}₂HSiO_{1/2} units are bonded to each other.

6. The UV-curable silicone composition according to claim 1 or 2, wherein the component (C) is a platinum catalyst having a cyclic diene compound as a ligand.

7. The UV-curable silicone composition according to claim 1 or 2, wherein
the UV-curable silicone composition comprises a first agent and a second agent,
the first agent comprises the component (A) and the component (C) and is free from the component (B), and
the second agent comprises the component (B) and is free from the component (C).

8. A sealant comprising a cured product of the UV-curable silicone composition according to claim 1 or 2.

9. The sealant according to claim 8, which is an electronic component encapsulant, an optical component encapsulant, or a bonding material.
